# EUROPEAN PATENT APPLICATION

(11) **EP 2 866 135 A2**
(43) Date of publication of application: **29.04.2015**
(21) Application number: 14182942.4
(22) Date of filing: 29.08.2014
(51) Int. Cl.: G06F 3/06

(54) **Server system and storage system**

(30) Priority: 25.10.2013 KR 20130127671
(71) Applicant: Samsung Electronics Co., Ltd, Gyeonggi-do 443-742 (KR)
(72) Inventor: Bae, Sun-gun, Gyeonggi-do (KR); Kim, Dong-gyu, Seoul (KR); Lee, Jae-sung, Gyeonggi-do (KR)
(74) Representative: Taor, Simon Edward William

(57) **Abstract**

A storage system includes a communication unit configured to perform communication with a server, a storage unit including a plurality of storage media, an input/output (I/O) controller configured to transmit/receive data to/from the server through the communication unit, and transmit/receive the data to/from the storage unit, and a board unit in which the storage unit and the I/O controller are disposed, and configured to transmit/receive the data between the storage unit and the I/O controller by using a pattern.

## Description

Embodiments of the inventive concept relate to apparatuses and methods for a server system and a storage system, and more particularly, to a server system and a storage system configured to connect to a plurality of storage media, and an input/output (I/O) controller using patterns in a main board.

The development of high-speed Internet and Intranet technology has increased demand for server technology configured to process large amounts of data at high speed. This has led to the emergence of rack-mounted cluster server technology. However, rack-mounted cluster servers occupy large volumes of space and power consumption of these servers has been increasing. Further, the ability to extend a system is limited because the server modules have to be connected through cables.

In response to this concern, micro servers that use processor modules have been developed. Processor modules are thin modular installation product servers that operate by inserting servers into a main body of a micro server system, not by stacking servers as is done with rack-mounted servers. The processor modules are referred to as high-density servers because a lot of servers are inserted and installed in a narrow space. The core elements of such a server include one or more central processing units (CPUs), a storage device, and/or an operating system. These elements are built in the processor module, and the processor module receives power, input/output (I/O) functions, additional devices, and/or various control functions from the main body to perform the functions of a server.

More recently, servers tend to use the storage space of an external storage system rather than their own storage spaces. For this reason, storage systems configure to store data at a high degree of density are needed.

However, because storage systems in the related art include a storage medium and an I/O card that are connected through a cable, connections within these systems may be complex. Particularly, in situations in which air flow through the system is blocked by a cable, heat removal from the system may be poor. The above-described issues may be further exacerbated when storage systems are configured to include a lot of storage media, which increases the degree of integration.

Additional features and utilities of the present general inventive concept will be set forth in part in the description which follows and, in part, will be obvious from the description, or may be learned by practice of the general inventive concept.

The foregoing and/or other features and utilities of the present general inventive concept may be achieved by providing a storage system connectable to a server, the storage system including a communication unit configured to perform communication with the server, a storage unit including a plurality of storage media, an input/output (I/O) controller configured to transmit/receive data to/from the server through the communication unit, and transmit/receive the data to/from the storage unit, and a board unit in which the storage unit and the I/O controller are disposed, and configured to transmit/receive the data between the storage unit and the I/O controller by using a pattern.

The I/O controller may cause the server to share and use storage spaces of the plurality of storage media.

The storage system may further include a first interface bus configured to transmit/receive the data and a first control command between the server and the I/O controller, and a second interface bus configured to transmit/receive the data and a second control command between the I/O controller and the plurality of storage media. The second interface bus may be at least one of a serial attached small computer system interface (SCSI) (SAS), a serial advanced technology attachment (SATA), and a non-volatile memory express (NVMe) interface.

The first interface bus may be a peripheral component interconnect (PCI) Express interface bus.

The storage system may further include a signal processor disposed in the board unit, and configured to perform de-emphasis processing on a first signal transmitted from at least one of the storage unit and the I/O controller, and may perform equalizer processing on a second signal received in at least one of the storage unit and the I/O controller.

The board unit may include a slot for connection to the I/O controller, and the I/O controller may be configured to be mounted on and detached from the slot.

The slot may include a first slot configured to transmit/receive a first signal between the communication unit and the I/O controller, and a second slot configured to transmit/receive a second signal between the I/O controller and the plurality of storage media.

The first slot and the second slot may be consecutively disposed.

The first slot and the second slot may be disposed to be spaced apart, and the second slot may have a pin arrangement specification of a PCI Express interface.

Each of the storage media may be at least one of a hard disc drive (HDD) and a solid state disc (SSD).

The board unit may further include a plurality of third slots for connection to the plurality of storage media. The plurality of storage media may be configured to be mounted on and detached from the third slots.

Each of the plurality of storage media may be configured to be mounted on and detached from each of the third slots through a sub board disposed perpendicular to the board unit.

The sub board may include two fourth slots configured to connect to two storage media.

The storage system may further include a plurality of brackets configured to fix the two storage media and the sub board to the board unit.

The plurality of third slots may be disposed at preset intervals to accommodate storage modules.

The storage system may further include a baseboard management controller (BMC) unit configured to provide intelligent platform management interface (IPMI) service for the storage system using status information of the storage system.

The storage system may further include a microcomputer unit configured to collect status information of the plurality of storage media and status information of an inside of the storage system, provide the collected information to baseboard management controller (BMC) unit, and control an operation state of the storage system according to a control command provided from baseboard management controller (BMC) unit.

The storage system may further include a sensor unit configured to sense a temperature of the inside of the storage system and provide the sensed temperature to the microcomputer unit, a power unit configured to supply power to the storage system and change a power supply method according to control of the microcomputer unit, and a fan unit configured to cause air to flow in the inside of the storage system according to control of the microcomputer unit.

The storage system may further include a chassis configured to wrap the storage system, and the chassis may have a width and a depth so that the chassis may be installable in a 19-inch standard rack.

The foregoing and/or other features and utilities of the present inventive concept also provide a server system. The server system may include a server including a plurality of processor modules and a storage system including a plurality of storage media and an input/output (I/O) controller configured to provide data stored in the plurality of storage media to the server. The storage system may be configured to transmit/receive data between the plurality of storage media and the I/O controller through a pattern on a circuit board.

The foregoing and/or other features and utilities of the present inventive concept also provide a circuit board of a storage system usable in a server system. The circuit board may include one or more first slots disposed in rows along a width of the circuit board and configured to be connected to storage media of the storage system usable in the server system, a second slot disposed near a first end and along a length of the circuit board and configured to be connected to an input/output controller of the storage system, and a first conductive track printed on the circuit board to electrically connect the one or more first slots to the second slot.

The circuit board may be a single circuit board and an implementation of the first conductive track may exclude use of a cable.

The circuit board may further include a communication connector disposed near the first end of the circuit board and configured to be connected to a communication unit of the storage system, and a second conductive track printed on the circuit board to electrically connect the second slot to the communication connector.

The circuit board may further include a chassis configured to house the storage system.

The circuit board may further include a fan connector disposed at a second end of the circuit board and configured to be connected to a fan unit of the storage system. The second end of the circuit board may be at a front end of the storage system.

The circuit board may further include a sensor unit disposed on the circuit board near the first end. The sensor unit may be configured to measure temperature.

The circuit board may further include a microcomputer unit disposed on the circuit board and configured to at least one of receive information from a sensor unit, control a fan unit, receive status information of the storage system and transmit the status information to a baseband management controller unit, control an operation of the storage system according to a command from the baseband management controller unit, detect an operational state of a power unit, and control an operation of the power unit. The circuit board may further include a third conductive track printed on the circuit board to electrically connect the microcomputer unit to the sensor unit. The circuit board may further include a fourth conductive track printed on the circuit board to electrically connect the microcomputer unit to the baseband management controller unit.

The circuit board may further be configured so that the microcomputer unit includes a first microcomputer disposed on a first side of the circuit board, and a second microcomputer disposed on a second side of the circuit board, the sensor unit includes a plurality of sensors, and a first group of the plurality of sensors is configured to send first signals to the first microcomputer, and a second group of the plurality of sensors is configured to send second signals to the second microcomputer.

The circuit board may further include a baseband management controller unit disposed on the circuit board and configured to at least one of communicate with a management server, receive status information of the storage system from the microcomputer unit, provide a command to the microcomputer unit about operation of the storage system, divide the storage media into groups, and provide a service based on an intelligent platform management interface specification for the storage system. The circuit board may further include a fifth conductive track printed on the circuit board to electrically connect the baseband management controller unit to the second slot.

The circuit board may further be configured so that the storage media is configured into a first group of storage media in which an operating system is stored, and a second group of storage media which is accessible to a server of the server system.

The circuit board may further include a power slot disposed at the first end of the circuit board and configured to be electrically connected to a power unit of the storage system.

The circuit board may further include an auxiliary connector disposed on the circuit board and configured to be connected to an input/output controller having a connection interface different from the second slot.

The foregoing and/or other features and utilities of the present inventive concept also provide an input/output controller of a storage system usable in a server system. The input/output controller may include a chip mounted on a board, a first connector disposed at an end of the board, connected to a first signal line connected to the chip, and configured to facilitate communication of first information between the chip and a server usable in the server system according to a first interface bus method, and a second connector disposed at the end of the board, connected to a second signal line connected to the chip, and configured to facilitate communication of second information between the chip and storage media of the storage system of the server system according to a second interface method. The first connector and the second connector may be implemented as a single connector.

The first interface bus method may be an interface that operates according to a Peripheral Component Interconnect Express standard, and the second interface bus method may be an interface that operates according to at least one of a Serial Attached Small Computer System Interface protocol, a Serial Advanced Technology Attachment protocol, and a Non-Volatile Memory Express specification.

The foregoing and/or other features and utilities of the present inventive concept also provide a signal processor system of a storage system usable in a server system. The signal processor system may include a first signal processor configured to perform de-emphasis processing on a first signal transmitted from at least one of a storage unit usable in the storage system of the server system and an input/output controller of the storage system, and a second signal processor configured to perform equalizer processing on a second signal received at at least one of the storage unit and the input/output controller.

These and/or other features and utilities of the present general inventive concept will become apparent and more readily appreciated from the following description of the embodiments, taken in conjunction with the accompanying drawings of which:
FIG. 1 is a block diagram illustrating a configuration of a server system according to an exemplary embodiment of the present inventive concept;
FIG. 2 is a block diagram illustrating an example of a configuration of a storage system illustrated in FIG. 1;
FIG. 3 is a diagram illustrating an example of a connection state between a storage unit and an input/output (I/O) controller illustrated in FIG. 2;
FIG. 4 is a perspective view illustrating an example of a shape of a storage system illustrated in FIG. 1;
FIGS. 5, 6 and 16 are views illustrating an example of a shape of a board unit illustrated in FIG. 2;
FIG. 7 is a detailed view illustrating an example of a connection between an I/O controller and a board unit;
FIG. 8 is a view illustrating an example of a shape of an I/O controller illustrated in FIG. 1;
FIG. 9 includes views illustrating examples of a storage module according to exemplary embodiments of the present inventive concept;
FIG. 10 is a block diagram illustrating examples of connections among a baseboard management controller (BMC) unit, a microcomputer unit, and a sensor unit illustrated in FIG. 2;
FIG. 11 is a perspective view illustrating an example of an auxiliary connector illustrated at FIGS. 5 and 6;
FIG. 12 is a block diagram illustrating a signal processor according to an exemplary embodiment of the present inventive concept;
FIG. 13 is a view illustrating an air flow simulation result of a storage system according to an exemplary embodiment of the present inventive concept;
FIG. 14 is a view illustrating a heat simulation result of a storage system according to an exemplary embodiment of the present inventive concept; and
FIG. 15 is a view illustrating a heat simulation result of a storage system in the related art.

Reference will now be made in detail to the embodiments of the present general inventive concept, examples of which are illustrated in the accompanying drawings, wherein like reference numerals refer to the like elements throughout. The embodiments are described below in order to explain the present general inventive concept while referring to the figures.

The matters defined in the description, such as detailed construction and elements, are provided to assist in a comprehensive understanding of the exemplary embodiments of the present inventive concept. One of skill in the art understands that the exemplary embodiments of the present inventive concept may be carried out without those specifically defined matters. Also, functions or elements known in the related art are not described in detail since doing so would obscure the description of the exemplary embodiments of the present inventive concept with unnecessary detail.

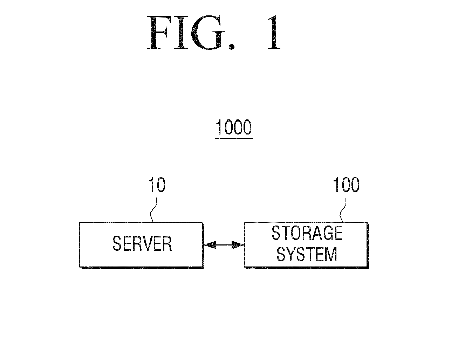

FIG. 1 is a block diagram illustrating a configuration of a server system according to an exemplary embodiment of the present inventive concept.

Referring to FIG. 1, a server system 1000 according to an exemplary embodiment of the present inventive concept may include a server 10 and a storage system 100.

The server 10 may be, for example, a computer system configured to provide different computer services by using a plurality of processor modules. The processor modules may be, for example, thin modular installation product servers that operate by inserting the servers into a main body of a micro server system, not by stacking servers as is done with rack-mounted servers. The processor modules may be referred to as high-density servers because a lot of servers may be inserted and installed in a narrow space. The core elements of such a server may include, for example, one or more central processing units (CPUs), a storage device, and/or an operating system. These elements may be built in the processor module, and the processor module may receive power, input/output (I/O) functions, additional devices, and/or various control functions from the main body to perform the functions of a server.

The server 10 may perform jobs required from -outside the server system 1000 by using data stored in the storage system 100. The server 10 may communicate with an external system using a wired and/or wireless communication method.

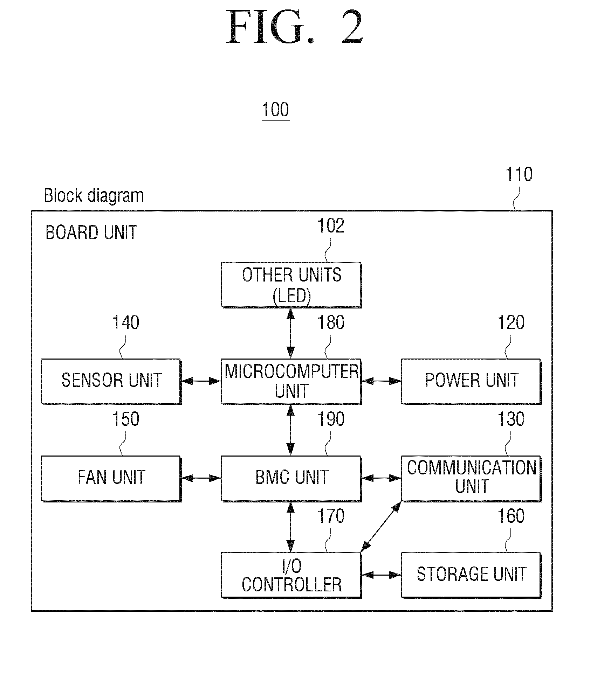

The storage system 100 may include a plurality of storage media 160 (see FIG. 2) and an input/output (I/O) controller 170 (see FIG. 2) configured to provide data stored in the plurality of storage media to the server 10. The storage system 100 may transmit and/or receive data between the storage media 160 and the I/O controller 170 by using patterns, such as, for example, conductive tracks, on a circuit board rather than use of a cable (not illustrated). A detailed description of a configuration and operation of the storage system 100 is provided below with reference to FIG. 2.

The server system 1000 illustrated in FIG. 1 is for a server system 1000 in which the storage system 100 may be connected to one server 10. However, the storage system 100 may be implemented to be connected to a plurality of servers 10. Further, although not illustrated in FIG. 1, the storage system 100 may be connected to a server 10 configured to process service as well as to a management server configured to remotely manage the server 10 and/or the storage system 100.

FIG. 2 is a block diagram illustrating an example of a configuration of the storage system illustrated in FIG. 1.

Referring to FIG. 2, the storage system 100 according to an exemplary embodiment of the present inventive concept may include a board unit 110. The board unit 110 may include a power unit 120, a communication unit 130, a sensor unit 140, a fan unit 150, a storage unit 160, an input/output (I/O) controller 170, a microcomputer unit 180, a baseboard management controller (BMC) unit 190, and, optionally, other units 102. The storage system 100 may have a size (19"x39") that may be installable in a 19-inch standard rack.

The board unit 110 may be, for example, a printed circuit board (PCB) in which a variety of components of the storage system 100 may be disposed. The board unit 110 may be a two-sided PCB having conductive layers on both sides. Alternatively, the board unit 110 may be a multi-layered PCB in which layers of patterns may be buried inside thereof. The board unit 110 may have a size (for example, 16.3"x32.6") that may be mountable on a structure that has a standard two unit server size (2U).

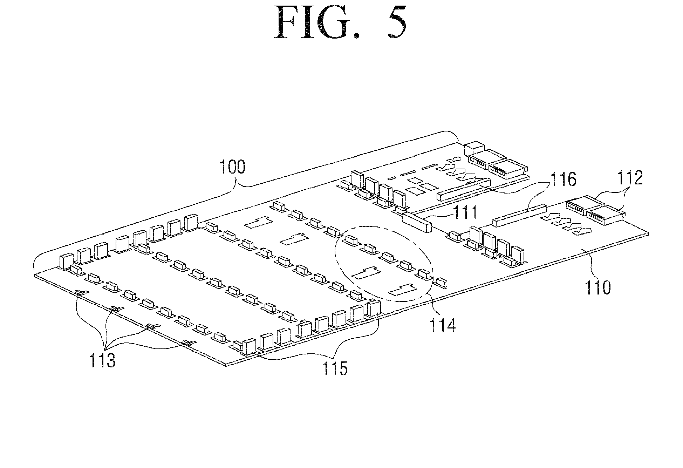

The board unit 110 may include slots for physical/electrical connection to components in the storage system 100. For example, as illustrated in FIG. 5, the board unit 110 may include a power slot 111, a communication connector 112, a fan connector 113, a storage slot 114, an auxiliary connector 115, an I/O slot 116, or the like. Functions and operations of the slots are described below with reference to FIGS. 5 to 7.

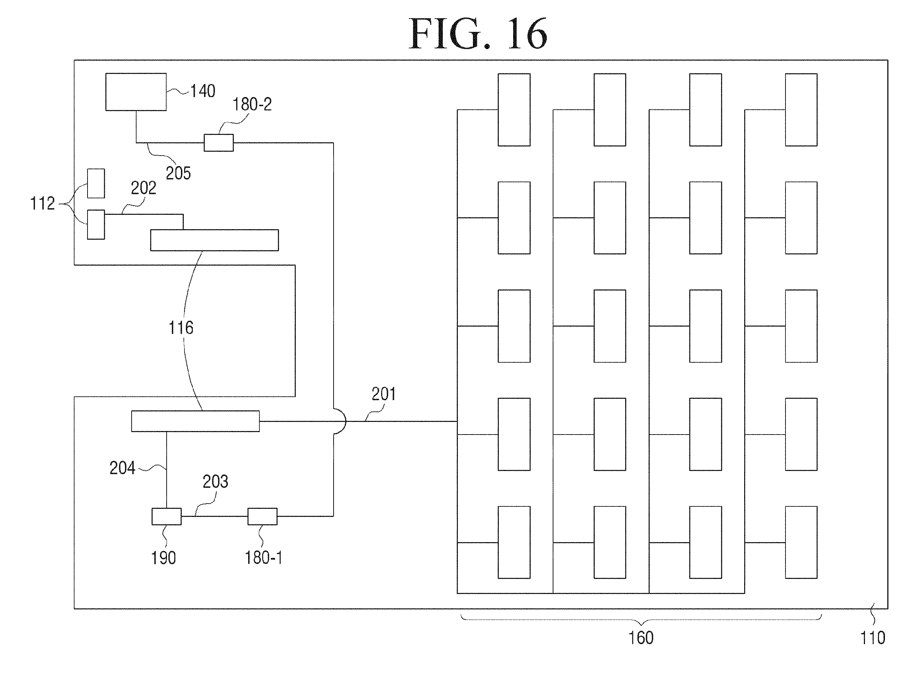

The board unit 110 may include patterns configured to transfer signals between the components in the storage system 100 on a circuit board (for example, a PCB). For example, the board unit 110 may include a first pattern 201 (see FIG. 16) configured to transfer a signal between the storage unit 160 and the I/O controller 170, and a second pattern 202 (see FIG. 16) configured to transfer a signal between the I/O controller 170 and the communication unit 130. In an exemplary embodiment of the present inventive concept, the board unit 110 may include only the first pattern 201 and the second pattern 202. Alternatively, a pattern 203 (see FIG. 16) configured to transfer a signal between the microcomputer unit 180 and the BMC unit 190, a pattern 204 (see FIG. 16) configured to transfer a signal between the I/O controller 170 and the BMC unit 190, a pattern 205 (see FIG. 16) configured to transfer a signal between the microcomputer unit 180 and the sensor unit 140, or the like may be further disposed in the board unit 110. The patterns may be disposed on an upper surface and/or a lower surface of the PCB. In some cases, the patterns may be disposed in an internal layer of the PCB.

The board unit 110 may receive power through the power unit 120, and may provide the received power to components in the storage system 100 through the patterns on the board unit 110.

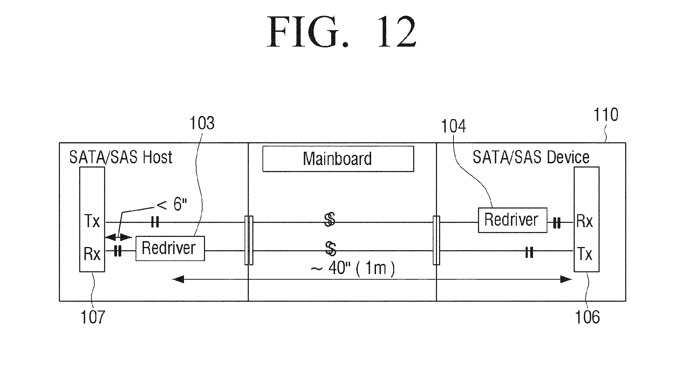

The board unit 110 may include, for example, first and second signal processors 103 and 104 (see FIG. 12) configured to prevent signal distortion which may be generated during signal transfer. The first and second signal processors 103 and 104 are described below with reference to FIG. 12.

The power unit 120 may supply power to the components in the storage system 100. For example, the power unit 120 may include a plurality of power supplies that have a power capacity that exceeds a maximum power capacity required by the storage system 100. The power unit 120 may drive the plurality of power supplies, for example, through a current-sharing method to supply power to the components in the storage system 100. The power unit 120 may supply power to the storage system 100 by using portions of the plurality of power supplies according to the magnitude of a load of the storage system 100.

The power unit 120 may be mounted and detached through the slot 111 formed in the board unit 110. The power unit 120 may provide, for example, information about whether alternating current (AC) is connected or disconnected, information about whether the power unit 120 is mounted or detached, information about the existence of lack of existence of an error, information about the current and/or voltage of the I/O controller 170, and/or information about the temperature to the BMC unit 190.

The communication unit 130 may perform communication with the server 10. For example, the communication unit 130 may perform communication with the server 10 by using, for example, an interface that operates according to the Peripheral Component Interconnect Express (PCIe) standard. In an exemplary embodiment of the present inventive concept, the communication unit 130 communicates with the server 10 by using an interface that operates according to the PCIe standard, but the communication unit 130 may be implemented to communicate with the server 10 according to other interface standards.

For example, when the storage system 100 operates according to the Network-Attached Storage (NAS) standard, the communication unit 130 may include a network controller and a Local Area Network (LAN) port, and may communicate with the server 10 according to the Ethernet standard. When the storage system 100 operates according to the Direct-Attached Storage (DAS) standard, the communication unit 130 may perform communication with the server 10 according to a Serial Attached Small Computer System Interface (SCSI) (SAS) protocol, a Serial Advanced Technology Attachment (SATA) standard, or a Non-Volatile Memory Express (NVMe) specification. When the storage system 100 operates with a Storage Area Network (SAN) file system, the communication unit 130 may communicate with the server 10 through a fiber channel.

The communication unit 130 may perform communication with a management server (not illustrated). For example, the communication unit 130 may include a network controller (not illustrated) and a LAN port (not illustrated), and may cause the BMC unit 190 to perform communication with the management server. The communication unit 130 may perform communication with the management server through an out of band (OOB) network channel configured to perform service for the management server that is separated from a network channel configured to perform service for the server 10.

In an exemplary embodiment of the present inventive concept, the communication unit 130 may perform communication with the management server (not illustrated) through a wired LAN port (not illustrated), but the communication unit 130 may also be implemented to perform communication with the management server using wired communication standards other than the LAN standards or wireless communication standards. Furthermore, in an exemplary embodiment of the present inventive concept, the server 10 and the management server are separated components, but the server 10 may be implemented to also perform a function of the management server.

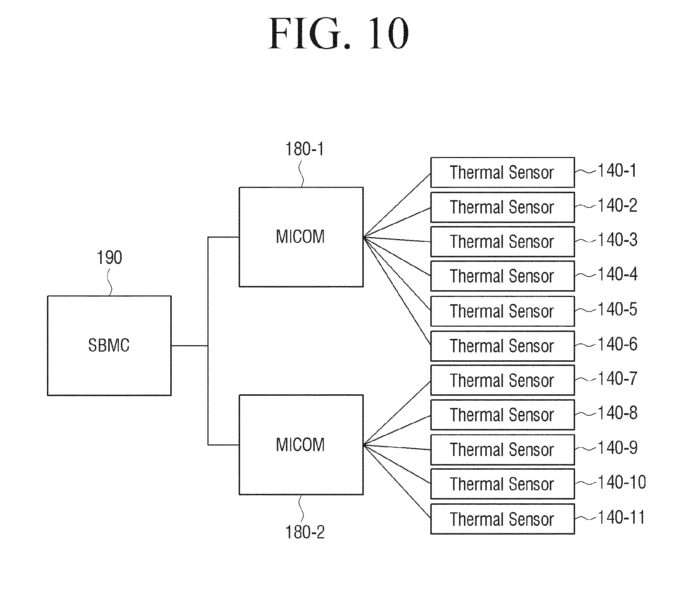

The sensor unit 140 may include a plurality of sensors (e.g., 140-1 through 140-11 at FIG. 10) disposed inside of the storage system 100, and configured to provide values sensed by the sensors to the microcomputer unit 180. The plurality of sensors may include a temperature sensor, but the plurality of sensors in embodiments of the invention are not limited thereto. When the microcomputer unit 180 includes a plurality of microcomputers (e.g., 180-1 and 180-2 at FIG. 10), the plurality of sensors may be divided into groups corresponding to the number of microcomputers (see FIG. 10), and each of the divided groups may transfer the sensed values to a corresponding microcomputer.

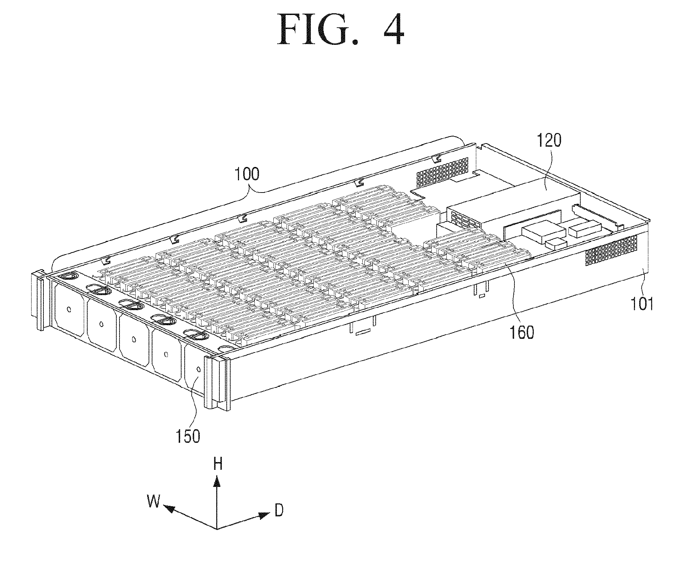

The fan unit 150 may cause air to flow inside of the storage system 100. For example, the fan unit 150 may be disposed in a front surface of the storage system 100 (see FIG. 4), and the fan unit 150 may cause external air to flow inside of the storage system 100 to cool the storage system 100. An operation of the fan unit 150 may be controlled by the microcomputer unit 180 to be described below.

The storage unit 160 may store data transferred under the control of the I/O controller 170 or may provide stored data to the I/O controller 170. For example, the storage unit 160 may include a plurality of storage media, and a storage medium of the plurality of storage media may include a Hard Disk Drive (HDD) or a Solid-State Disc (SSD). The storage unit 160 may be implemented, for example, to include only a plurality of HDDs or only a plurality of SDDs. Alternatively, the storage unit 160 may be implemented to include both HDDs and SSDs.

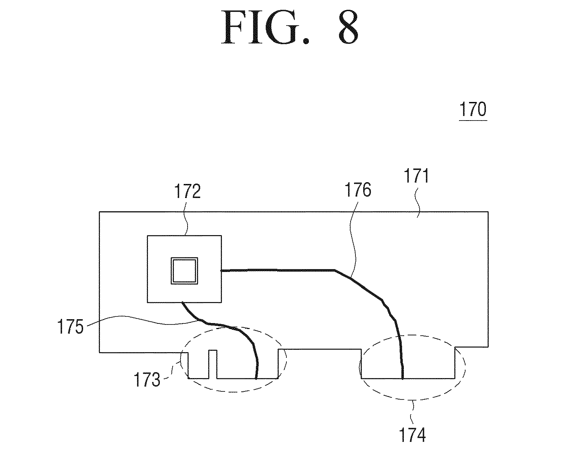

When the I/O controller 170 includes a plurality of I/O controllers (see FIG 8), the plurality of storage media may be divided into groups corresponding to the number of I/O controllers, and each of the divided groups may transmit/receive data to/from a corresponding I/O controller. For example, in an exemplary embodiment of the present inventive concept, 96 storage media may be disposed in the storage system 100, and two I/O controllers may transmit/receive data to/from the 96 storage media. That is, each of the two I/O controllers, for example, may transmit/receive data to/from 48 storage media.

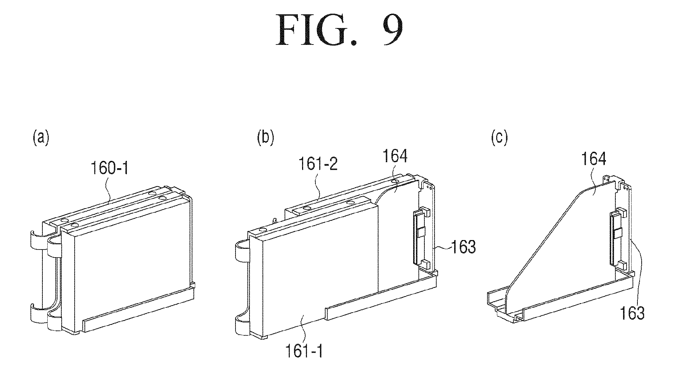

Each of the plurality of storage media constituting the storage unit 160 may be mounted and detached through the slot 114 (see FIG. 5) formed in the board unit 110. The connection method between the storage medium and the board unit 110 is described below with reference to FIG. 9.

The I/O controller 170 (or an I/O adapter) may transmit/receive data to/from the server 10 through the communication unit 130, and may transmit/receive data to/from the storage unit 160. For example, the I/O controller 170 may cause the server 10 to share and use storage spaces of the plurality of storage media. The I/O controller 170 may be implemented to cause a plurality of servers 10 to share and use the storage spaces of the plurality of storage media.

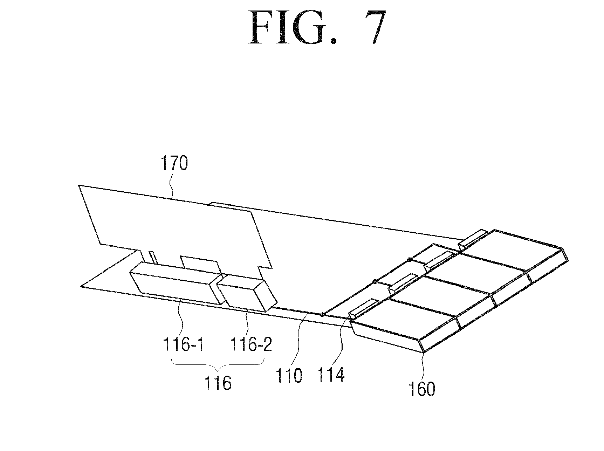

The I/O controller 170 may be mounted and detached through the slot 114 (see FIG. 5) formed in the board unit 110. For example, a connection method between the I/O controller 170 and the board unit 110 is described below with reference to FIGS. 7 and 8.

The I/O controller 170 may support, for example, I/O virtualization. For example, the board unit 110 may include a switch (not illustrated) on the slot 114 connected to the I/O controller 170, and the I/O controller 170 and the plurality of storage media may be selectively connected through the switch. The switch may be implemented, for example, through I/O virtualization technology. I/O virtualization technology refers to a technology in which plural processors simultaneously use one I/O card.

The I/O controller 170 may support a Redundant Array of Independent Disks (RAID) function. RAID is a technology in which partially overlapped data are divided and stored using plural storage media configured to operate as one storage medium.

The I/O controller 170 may perform de-emphasis processing on a signal transmitted to the storage medium 160 and/or the server 10, and may perform equalizer processing on a signal received from the storage medium160 and/or the server 10.

For example, a serial bus (not illustrated) refers to an interface configured to transmit data one bit unit of one bit at a time. For example, when a (recently developed) serial bus operates at high-speed, intersymbol interference (ISI), a skin effect (or a propagation effect), dielectric loss, or the like occurs. Skin effect refers to a reduction in conductivity or an increase in resistivity observed when current flow is logged in a material having strong conductivity. Dielectric loss refers to loss generated when an AC electric field is applied to a dielectric material. ISI refers to interference in which a symbol waveform of any time slot affects a symbol waveform of another time slot due to bandwidth limitations by a transmission line or an amplifier, or by the non-linearity of a phase of the transmission line.

ISI may be corrected by using de-emphasis technology or equalizer technology. For example, a signal may be transmitted from a transmission terminal of a serial bus (for example, an output terminal transmitter of a storage medium, or an output terminal of the I/O controller 170) using de-emphasis technology to take into account an effect of the ISI, and a received waveform may be improved at a reception terminal of the serial bus (for example, a reception terminal receiver of the storage medium or a reception terminal of the I/O controller 170) using the equalizer technology.

The I/O controller 170 may support, for example, a hot-swap on a storage medium. A hot-swap is a function in which devices or parts are replaced on an operating system without affecting on an overall operation of the system. If a hot-swap function is supported, then replacement/repair of devices or parts may be performed on the storage medium even when the storage system 100 is operating.

When HDDs are used as the storage media, the I/O controller 170 may control the storage unit 160 so that the HDDs are sequentially driven to reduce the magnitude of a total power load of the storage system 100. For example, to prevent system instability due to power consumption during an initial spin-up process of the HDD, the I/O controller 170 may sequentially drive a plurality of HDDs (i.e., a staggered drive spin-up).

The I/O controller 170 may include a memory (not illustrated) configured to temporarily store data between the server 10 and a storage medium. The memory may be, for example, a random access memory (RAM) or a flash memory. The memory may have at least one gigabyte of storage capacity.

The microcomputer unit 180 may collect status information of a plurality of storage media and status information of the inside of the storage system 100, and may provide the collected information to the BMC unit 190. The status information of the storage medium may be obtained, for example, through a Self-Monitoring, Analysis, and Reporting Technology (S.M.A.R.T) monitoring system. The status information of the inside of the storage system may include, for example, a temperature sensed by the sensor unit 140, a power supply state of the power unit 120, or the like. The S.M.A.R.T information is self-diagnostic information of an HDD detected in order to anticipate a possibility of a failure in advance. The S.M.A.R.T. information may include information about a basic mechanical disorder such as, for example, a height of a head, a data transmission rate, a number of revolutions per minute (RPM) of a disc, a number of sectors, an access error rate, an access speed, and/or a number of stops of an HDD.

The microcomputer unit 180 may control an operation of the storage system 100 according to a command provided from the BMC unit 190. For example, when a high temperature value in the storage system 100 is input through the sensor unit 140 and provided to the BMC unit 190, the BMC unit 190 may transmit an operation control command for the fan unit 150, and the microcomputer unit 180 may receive the operation control command to control the fan unit 150. The microcomputer unit 180 may be implemented to be divided into a plurality of microcomputers.

The BMC unit 190 may provide a service on the storage system 100 based on Intelligent Platform Management Interface (IPMI). The BMC unit 190 may include a baseboard management controller (BMC) (not illustrated). The BMC may be, for example, a microprocessor mounted on the server 10 or the storage system 100 and configured to support an IPMI. The BMC may provide information collected in the microcomputer unit 180 and medium management information collected from a plurality of storage media to a management server (not illustrated), may provide a control command, provided from the management server, to the microcomputer unit 180, and may manage temperature and power in the storage system 100. The BMC unit 190 may divide a plurality of storage media into a plurality of groups, and may perform power management and operation management for a first group in a manner that is different from the manner in which the BMC unit 190 performs these function for a second group. The medium management information may include information such as, for example, a manufacturer of the storage medium, a capacity of the storage medium, a speed of the storage medium, an error history of the storage medium, a temperature of the storage medium, or a general measure of the health of the storage medium.

IPMI is an open standard hardware management interface specification that defines a specific method in which an embedded management lower system is communicable to perform monitoring on a processor module, logging, recovery, inventory, and hardware control. In an exemplary embodiment of the present inventive concept, one BMC unit 190 collects status information of the plurality of microcomputers and transmits the collected status information to the management server, but alternatively a plurality of BMC units 190 may be used.

The BMC unit 190 may allocate a disc resource to the I/O controller 170 when a disc allocation request is received from the management server. For example, the BMC unit 190 and the I/O controller 170 may be connected through a System Management Bus (SMBus) interface.

The SMBus interface is an inter-integrated circuit (I2C) serial bus protocol-based interface that transfers a clock signal, data, and a command through a simple two-wired bus used in communication with low-speed devices on a motherboard.

The BMC unit 190 may request a disc reset or a disc change according to a magnitude of a load of each storage medium to perform an integration management solution based on storage medium management information received from the storage medium. For example, the BMC unit 190 may allocate an SDD resource that has a fast access speed to a host (e.g., a server) that has a high random access frequency, and may allocate an HDD resource to the host (e.g., the server) that has a high write frequency.

The storage system 100, according to an exemplary embodiment of the present inventive concept, may connect the storage medium and the I/O controller 170 without use of a cable in order to simplify a connection structure in the storage system 100. Therefore, a lot of storage media may be disposed. Since the I/O controller 170 may be mounted or detached through the slot 116, upgrade of the storage system 100 may be easily performed by replacing, for example, only the I/O controller 170. Furthermore, the connection structure is simplified without use of the cable so that cooling the storage system 100 may be improved.

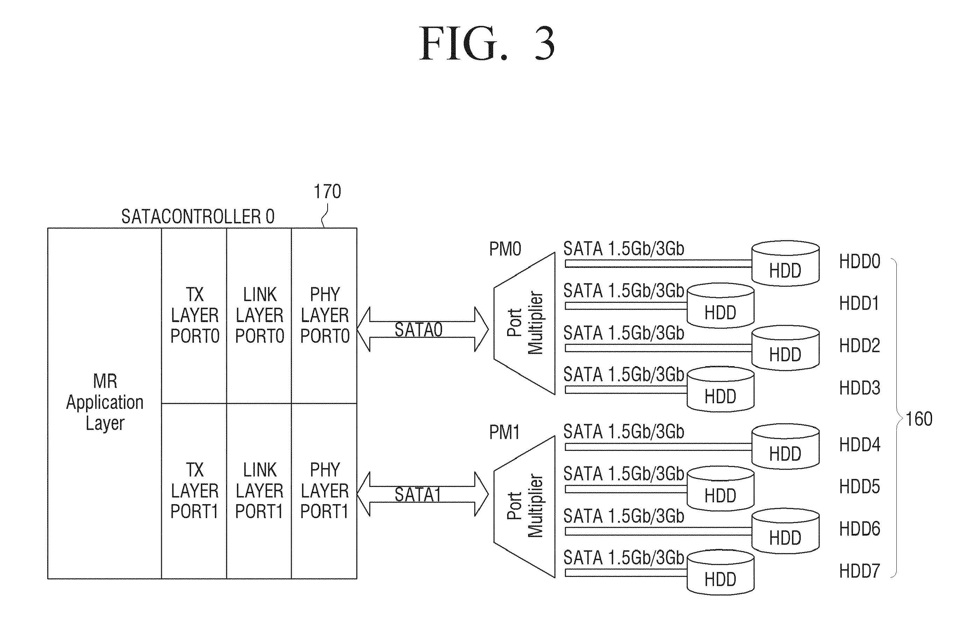

FIG. 3 is a diagram illustrating an example of a connection state between the storage unit 160 and the I/O controller 170 illustrated in FIG. 2.

Referring to FIG. 3, the storage unit 160 may include a plurality of storage media. The plurality of storage media may be grouped into a plurality of groups. For example, the plurality of storage media may be divided into a plurality of regions so that the storage unit 160 comprising the plurality of storage media is virtualized and shared. For example, each of the divided regions may be a private block and a virtual block. The private block may be a region in which an operating system (OS) is stored and which may be allocated to a specific server (not illustrated). The virtual block may be a region shared by servers. For example, information in each block may be managed through a mapping table (or matching table) (not illustrated), and the mapping table may be corrected by an external management server.

The I/O controller 170 may allocate a storage medium region to a server using a mapping table which matches blocks of the storage medium allocated to the servers.

Matching table information may be controlled by an external management server through the BMC unit 190, and when format information, partition information, block use information, installed OS information, or the like is provided to the external management server, the BMC unit 190 may provide a service based on an IPMI such as, for example, partition setting of an HDD, a block change, a size of a matching block, and a resetting.

The matching table stored in the external management server may be stored in the I/O controller 170 and in a server node (not illustrated) through a Burst Mode Controller (S-BMC) and a Trace Memory Controller (TMC) (a central processing unit (CPU) system management controller). For example, as illustrated in FIG. 3, the matching table stored in the external management server may be directly transferred to the storage system 100 through the S-BMC, transferred to a server, and transferred from the server to the I/O controller 170 through the TMC.

FIG. 4 is a perspective view illustrating an example of a shape of the storage system 100 illustrated in FIG. 1.

Referring to FIG. 4, a chassis 101 may wrap the storage system 100. The chassis 101 may have a width, a height, and a depth (e.g.,19"x3.5"x 39" (WxHxD)) installable, for example, in a 19-inch standard rack.

The fan unit 150, which may be configured to supply external air to the inside of the storage system 100. may be disposed in a front end of the chassis 101. In an exemplary embodiment of the present inventive concept, the fan unit 150 is disposed only in the front end of the chassis 101, but the fan unit 150 may also be implemented to be disposed in a rear end and a side of the chassis 101.

The communication unit 130 may be configured to perform communication with a server and the power unit 120, configured to supply power, may be disposed in the rear end of the chassis 101.

FIG. 4 illustrates that the storage system 100, according to an exemplary embodiment of the present inventive concept, has a size installable in a 19-inch standard rack, but the storage system 100 may also be implemented to have other sizes installable in racks other than the 19-inch standard rack.

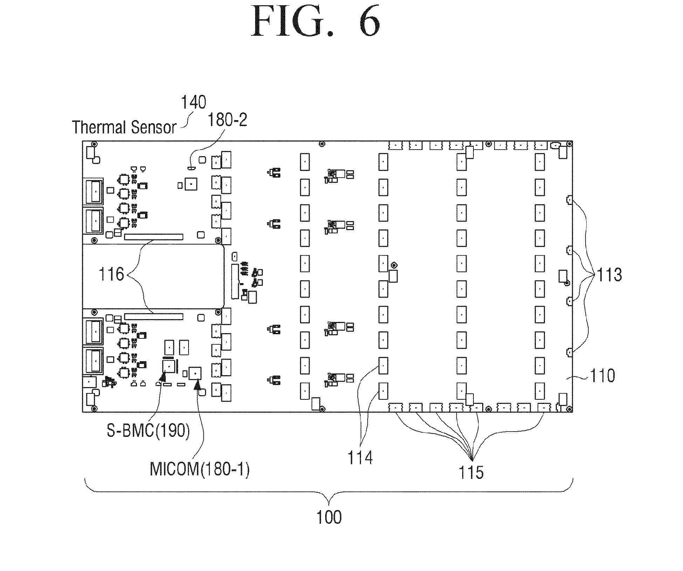

FIGS. 5 and 6 are views illustrating an example of a shape of the board unit 110 illustrated in FIG. 2.

Referring to FIGS. 5, 6, and 16, the board unit 110 may have a rectangular shape mountable on a standard server rack, and may include a groove, to which the power unit 120 may be disposed, in a rear end thereof.

Patterns configured to transfer signals between components in the storage system 100 may be disposed on an upper surface and/or a lower surface of the board unit 110. The patterns may be disposed in layers in a circuit board.

Connectors/slots for physical/electrical connection to the components in the storage system 100 may be disposed in the board unit 110. For example, the board unit 110 may include the power slot 111, the communication connector 112, the fan connector 113, the storage slot 114, the auxiliary connector 115, and the I/O slot 116.

The power slot 111 may be a slot configured to physically/electrically connect various terminals of the power unit 120 to the board unit 110, and power of the power unit 120 may be transferred, for example, to each component in the storage system 100 through the power slot 111. The microcomputer unit 180 may detect an operational state of the power unit 120 through the power slot 111 and may control an operation of the power unit 120 through the power slot 111.

The communication connector 112 may be a connector configured to physically/electrically connect the storage system 100 to the server 10, and may be disposed, for example, in a rear end of the board unit 110 to provide easy connection to the server 10. The communication connector 112 may be a PCI Express connector. In an exemplary embodiment of the present inventive concept, only the communication connector 112 may be configured for connection to the server 10, but alternatively the board unit 110 may be implemented so that additional connectors may be disposed for connection to Ethernet or a management server. The pattern 202 may connect the communication connector 112 to the input/output slot 116.

The fan connector 113 may be a connector configured to physically/electrically connect various terminals of the fan unit 150 to the board unit 110, and is disposed, for example, in a front end of the board unit 110 to provide easy connection to the fan unit 150. The fan connector 113 may transfer power of the power unit 120 to the fan unit 150. The microcomputer unit 180 may detect an operational state of the fan unit 150 through the fan connector 113 and may control an operation of the fan unit 150 through the fan connector 113.

The storage slot 114 may be a connector configured to physically/electrically connect a storage medium to the board unit 110, and may be an SATA connector. The storage slot 114 may transfer power of the power unit 120 to the storage medium, and may connect I/O ports (not illustrated) between the storage medium and the I/O controller 170. The pattern 201 may connect the storage slot 114 to the input/output slot 116.

The storage slot 114 may be disposed on the board unit 110, and the storage medium may be disposed to the board unit 110 in a length direction of the storage medium (i.e., a direction in which a surface having the largest length of the storage medium is perpendicular to the board unit 110). For example, a height of the storage system 100 may be larger than the length of the storage medium. To reduce the height of the storage system 100, the storage medium may be disposed to the board unit 110 in a width direction (i.e., the second longest length of the storage medium) using an auxiliary board 163 (see FIG. 9). An example using the auxiliary board 163 is described below with reference to FIG. 9.

The storage system 100, according to an exemplary embodiment of the present inventive concept, may include 48 storage slots in a width of a 19-inch standard rack as illustrated in FIG. 4, and each of the storage slots may be connected to two storage media. Therefore, the storage system 100, according to an exemplary embodiment of the present inventive concept, may use 96 storage media.

When the 96 storage media use one I/O board, the storage system 100, according to an exemplary embodiment of the present inventive concept, may have difficulty in connection uses two I/O controllers (not illustrated) and two microcomputers (not illustrated). In an exemplary embodiment of the present inventive concept, the plurality of storage media may be divided into two groups, but alternatively the plurality of storage media may be implemented as one group without dividing into a plurality of groups. Alternatively, the plurality of storage media may be implemented to be divided into three or more groups. The divided groups may perform, using a BMC, power control and operation control for a first group in a manner that is different from the manner in which these functions are performed for a second group.

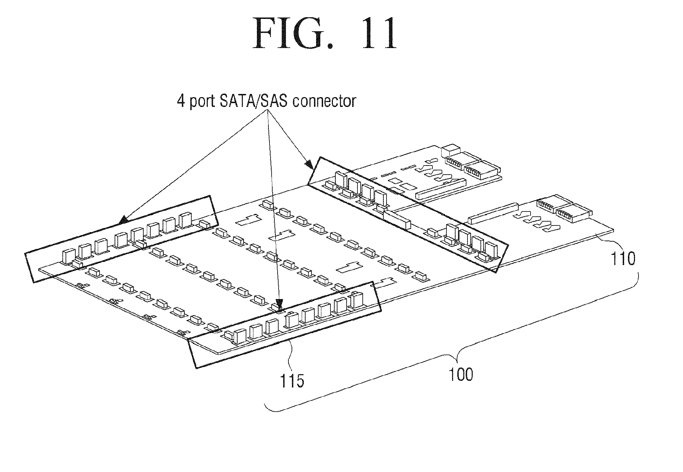

The auxiliary connector 115 may be a connector compatible with an I/O controller in the related art. A function and operation of the auxiliary connector 115 is described below with reference to FIG. 11.

Additionally, the pattern 203 may connect the microcomputer unit 180 to the BMC unit 190, the pattern 204 may connect the BMC unit 190 to the input/output slot 116, and the pattern 205 may connect the microcomputer unit 180 to the sensor unit 140.

The I/O slot 116 may be a slot configured to physically/electrically connect the I/O controller 170 to the board unit 110, and may include a first slot and a second slot. The configuration of the I/O slot 116 is described below with reference to FIGS. 7 and 8.

FIG. 7 is a detailed view illustrating an example of a connection between the I/O controller 170 and the board unit 110, and FIG. 8 is a view illustrating an example of a shape of the I/O controller 170 illustrated in FIG. 1.

Referring to FIGS. 7 and 8, the I/O controller 170 may include a sub board 171 and a chip 172.

The sub board 171 may include a first connector 173 and a second connector174 disposed in one side of the sub board 171 and spaced apart from each other. The first connector 173 may transmit/receive a signal through a first signal line 175 between the communication unit 130 and the chip 172, and may have a pin arrangement specification of a PCI Express interface. The first connector 173 may transmit/receive data and a control command between a server and the I/O controller 170 according to a first interface bus method. The first interface bus method may be a PCI Express interface bus method.

The PCI Express interface maintains software compatible with a PCI parallel interface bus, and is an improved serial local bus standard for high-speed I/O between devices. The PCI Express interface is suitable for processing large amounts of data.

The second connector 174 may transmit/receive a signal through a second signal line 176 between each of the plurality of storage media and the chip 172, and may have a pin arrangement as illustrated in Table 1 below. The second connector 174 may transmit/receive data and a control command between, for example, each of the plurality of storage media and the I/O controller 170 according to a second interface bus method. The second interface bus method may be at least one of an interface bus method of SAS, SATA, and NVMe.

The SAS method is one standard of a serial small computer system interface (SCSI), and the SAS method is an interface method in which high-speed interfacing may be possible since data is sequentially transmitted one bit by one bit to easily achieve data synchronization.

The SATA method uses a computer bus made mainly for data transfer to a hard disc or an optical disc drive, and transmits/receives data using four-wired signal lines TX-, TX+, RX-, and RX+. In this regard, a total of 144 pins including a ground are necessary to connect 24 SATA discs. Pin mapping is illustrated in Table 1 below, and the 144 pins may be implemented with one connector for PCI Express x16.

The NVMe method is an interface method for a storage medium using a nonvolatile memory such as a SSD.

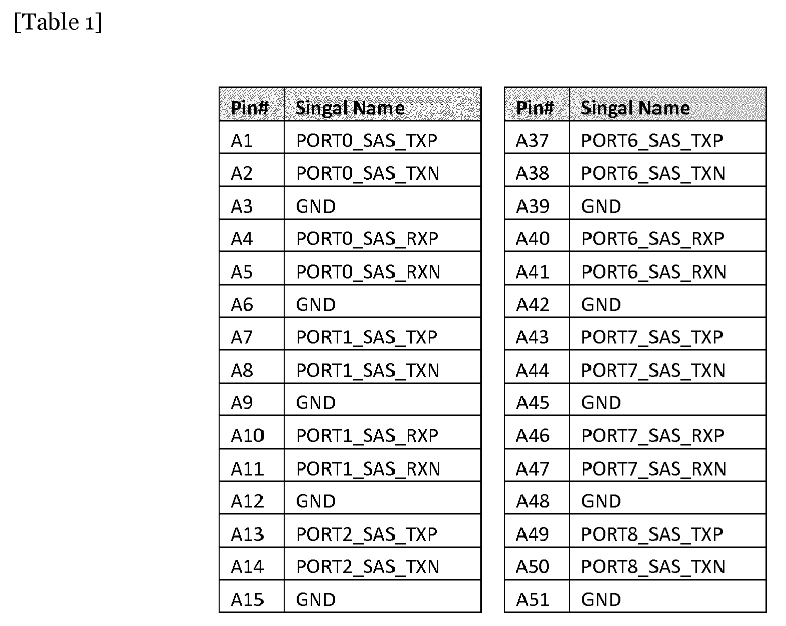

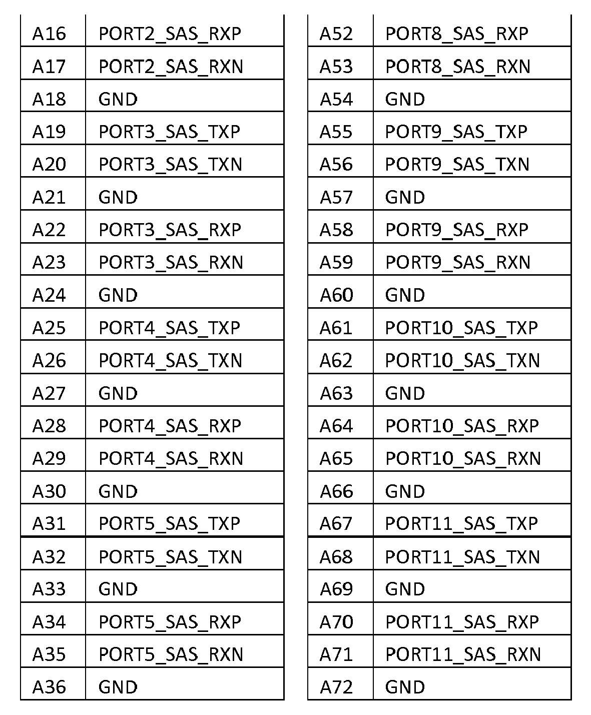

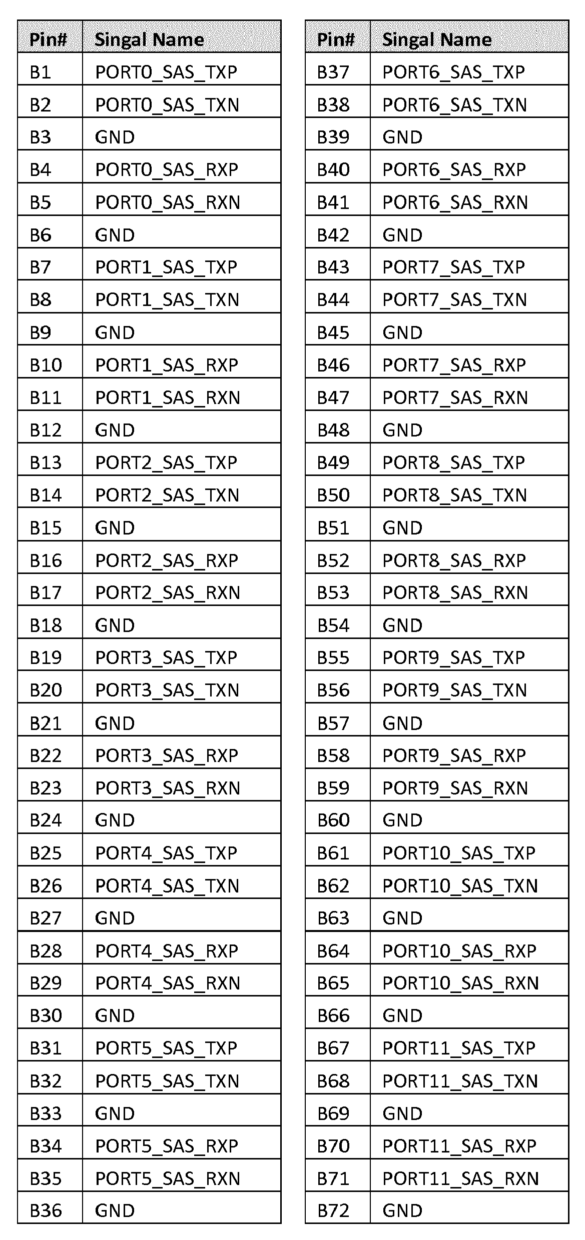

The I/O controller 170, according to an exemplary embodiment of the present inventive concept, may be electrically connected to the board unit 110 by coupling the first connector 173 to a first I/O portion 116-1 of the I/O slot 16 and the second connector 174 to a second portion 116-2 of the I/O slot 116, and thus the I/O controller 170 may be mounted on and detached from the storage system 100. Therefore, a system upgrade effect may be obtained, for example, only by replacing an existing I/O controller 170 with an improved I/O controller 170.

FIGS. 7 and 8 illustrate an embodiment of the present inventive concept in which the first connector 173 is spaced apart from the second connector 174, but alternatively the sub board 171 may be implemented so that the first connector 173 and the second connector 174 are not to be spaced apart. That is, the first connector 173 and the second connector 174 may be physically implemented with one connector.

FIG. 9 includes views illustrating examples of a storage module according to exemplary embodiments of the present inventive concept.

Referring to a view (a) of FIG. 9, in the storage unit 160, according to an exemplary embodiment of the present inventive concept, two storage media may constitute one storage module 160-1. The storage modules 160-1 may be disposed on the board unit 110 at preset intervals.

As illustrated at views (b) and (c) of FIG. 9, one storage module 160-1, including, for example, a first storage media 161-1 and a second storage media 161-2, may be connected to the board unit 110 through one sub board 163 and a bracket 164.

The sub board 163 may be detached from and mounted on the storage slot 114 of the board unit 110, and may include two slots (not illustrated) to which connectors of the storage medium may be detached from or mounted on. In an exemplary embodiment of the present inventive concept, the two slots may be included in the sub board 163, but the sub board 163 may also be implemented to include, for example, only one slot.

The sub board 163 may include a display device (not illustrated) such as, for example, a light emitting diode (LED) (not illustrated) configured to display whether the storage medium that is connected thereto operates. The display device may also display whether the storage medium operates and/or whether an error occurs, and thus a manager may easily find a disordered storage medium among a collection of storage media.

The bracket 164 may fix the two storage media and the sub board 163 to the board unit 110.

As described above, the storage medium may be connected to the board unit 110 through the slot 114 so that the storage system 100 may support a hot-swap on the storage medium. A hot-swap is a function in which devices or parts are replaced while operating without affecting an overall operation of the operating system.

The exemplary embodiment has illustrated that the storage medium is connected to the board unit 110 through the sub board. However, when a height of the storage system 100 is larger than a length of an HDD (the longest length of a width, a height, and a depth), the storage medium may be vertically mounted on the board unit 110 in an upright manner without use of the sub board. At this time, the display device such as an LED configured to display whether the storage medium operates may be disposed on the board unit 110.

FIG. 10 is a block diagram illustrating examples of connections among the BMC unit 190, the microcomputer unit 180, and the sensor unit 140 illustrated in FIG. 2.

Referring to FIG. 10, the sensor unit 140 may include a plurality of sensors 140-1 through 140-11. The plurality of sensors 140-1 through 140-11 may be divided into two groups. Sensors 140-1 through 140-6 of the first group may be connected to a first microcomputer 180-1 and sensors 140-7 through 140-110f the second group may be connected to a second microcomputer 180-2.

The first microcomputer 180-1 may read sensed values of the sensors 140-1 through 140-6 of the first group, and may provide the sensed values to the BMC unit 190. The second microcomputer 180-2 may read sensed values of the second sensors 140-7 through 140-11 of the second group, and may provide the sensed values to the BMC unit 190.

The BMC unit 190 may control the fan unit 150 based on temperature information received from the first microcomputer 180-1 and the second microcomputer 180-2.

FIG. 11 is a perspective view illustrating an example of the auxiliary connector 115 illustrated at FIGS. 5 and 6.

The auxiliary connector 115 may be a connector configured to connect an I/O connector in the related art and a storage medium. For example, as described in Description of the Related Art, an I/O controller and a storage medium are connected through a cable in the related art.

That is, the I/O controller has to be connected to the storage medium only through the cable in the related art. However, in an exemplary embodiment of the present inventive concept, to be compatible with the I/O controller in the related art, the auxiliary connector 115 has to be connected to patterns between the storage medium and the I/O controller 170 that is disposed on one side of the board unit 110.

Alternatively, the auxiliary connector 115 may be disposed on both side ends of the board unit 110 in order not to interfere with air flow in the storage system 100. The auxiliary connector 115 may be, for example, 4-port SATA/SAS connector.

The auxiliary connector 115 may be necessary only for compatibility, and may not be essential to the configuration of the board unit 110. Thus, the auxiliary connector 115 may be omitted.

FIG. 12 is a block diagram illustrating a signal processor according to an exemplary embodiment of the present inventive concept.

A serial bus refers to an interface configured to transmit data one bit unit or one bit at a time. When a (recently developed) serial bus operates at a high-speed, intersymbol interference (ISI), a skin effect (or a propagation effect), dielectric loss, or the like occurs. Skin effect refers to a reduction in conductivity or an increase in resistivity observed when current flow is logged in a material having strong conductivity, and the dielectric loss refers to loss generated when an AC electric field is applied to a dielectric material. ISI refers to interference in which a symbol waveform of any time slot affects a symbol waveform of another time slot due to bandwidth limitations by a transmission line or an amplifier, or by the non-linearity of a phase of the transmission line.

ISI may be corrected by using de-emphasis technology or equalizer technology. For example, a signal may be transmitted from a transmission terminal of a serial bus (for example, an output terminal transmitter of a storage medium, or an output terminal of the I/O controller 170) using the de-emphasis technology to take into account an effect of the ISI, and a received waveform may be improved at a reception terminal of the serial bus (for example, a reception terminal receiver of the storage medium or a reception terminal of the I/O controller 170) using the equalizer technology.

The first and second signal processors 103 and 104 may be disposed in the board unit 110, and may perform de-emphasis processing on a signal transmitted from the storage unit 160 or the I/O controller 170. The first and second signal processors 103 and 104 may also perform equalizer processing on a signal received in the storage unit 160 or the I/O controller 170. The first signal processor 103 may be configured to process a signal received through a transceiver unit 107 and transmitted through a transceiver unit 106. Conversely, the second signal processor 104 may be configured to process a signal received through the transceiver unit 106 and transmitted through the transceiver unit 107.

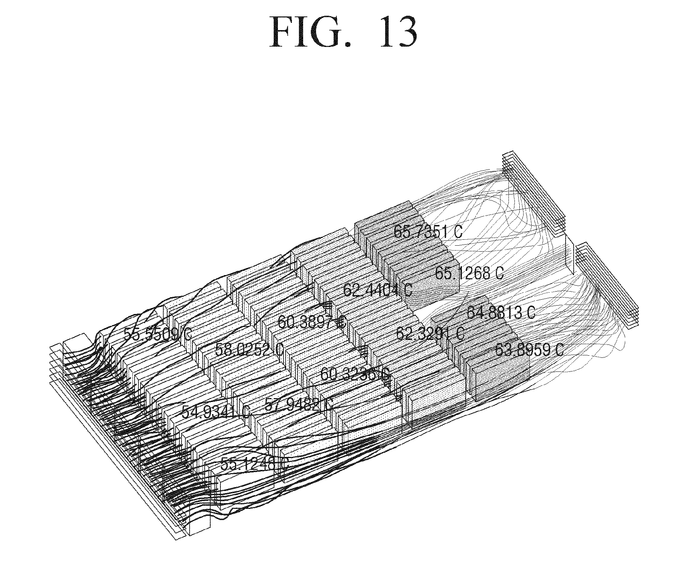

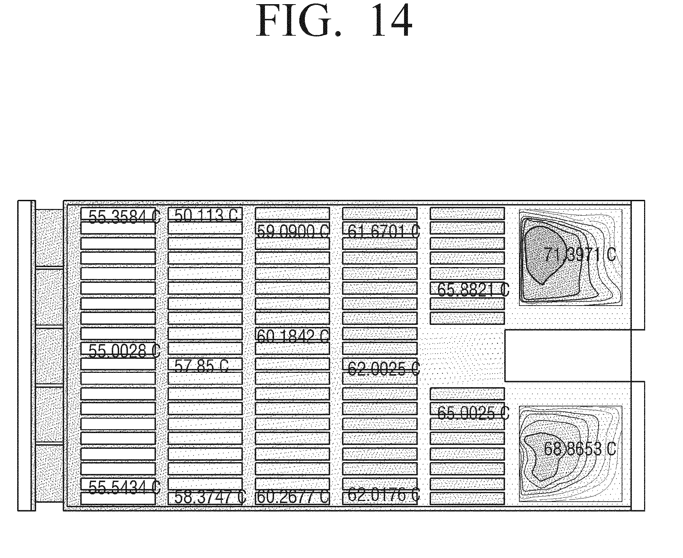

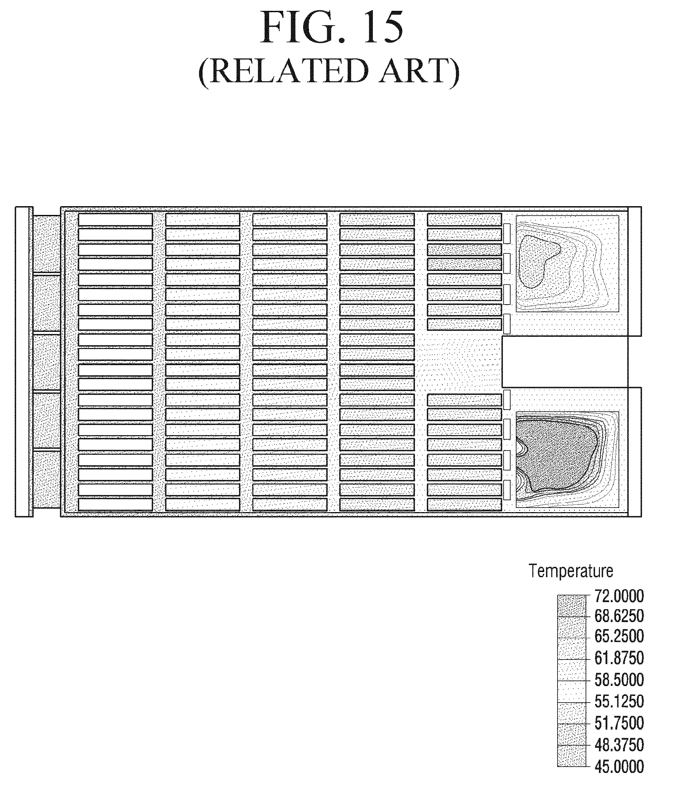

FIG. 13 is a view illustrating an air flow simulation result of the storage system 100, and FIG. 14 is a view illustrating a heat simulation result of the storage system 100. FIG. 15 is a view illustrating a heat simulation result of a storage system in the related art.

FIG. 13 illustrates that, with the absence of a cable inside of the storage system 100 according to the exemplary embodiment of the present inventive concept, the air flow in the storage system 100 is more smooth.

FIGS. 14 and 15 illustrate that because the air flow in the storage system 100 according to an exemplary embodiment of the present inventive concept is smoother than the air flow in a storage system in the related art, a temperature in the storage system 100 is lower than a temperature in a storage system in the related art.

The circuit board 110 of the storage system 100 usable in the server system 1000 may include one or more first slots 114, the second slot 116, and the first conductive track 201. The one or more first slots 114 may be disposed in rows along a width of the circuit board 110 and may be configured to be connected to storage media usable in the storage system 100 of the server system 1000. The second slot 116 may be disposed near a first end and along a depth of the circuit board 110 and may be configured to be connected to the input/output controller 170 of the storage system 100. The first conductive track 201 may be printed on the circuit board 110 to electrically connect the first set of slots 114 to the second slot 116. The circuit board 110 may be a single circuit board 110 and an implementation of the first conductive track 201 may exclude use of a cable.

The circuit board 110 may further include the communication connector 112 and the second conductive track 202. The communication connector 112 may be disposed near the first end of the circuit board 110 and may be configured to be connected to the communication unit 130 of the storage system 100. The second conductive track 202 may be printed on the circuit board 110 to electrically connect the second slot 116 to the communication connector 112.

The circuit board 110 may further include the chassis 101 configured to house the storage system 100.

The circuit board 110 may further include the fan connector 113. The fan connector 113 may be disposed at a second end of the circuit board 110 and may be configured to be connected to the fan unit 150 of the storage system 100. The second end of the circuit board 110 may be at a front end of the storage system 100.

The circuit board 110 may further include the sensor unit 140. The sensor unit 140 may be disposed on the circuit board 110 near the first end. The sensor unit 140 may be configured to measure temperature.

The circuit board 110 may further include the microcomputer unit 180. The microcomputer unit 180 may be disposed on the circuit board 110 and may be configured to receive information from the sensor unit 140, control the fan unit 150, receive status information of the storage system 100 and transmit the status information to the baseband management controller unit 190, control an operation of the storage system 100 according to a command from the baseband management controller unit 190, detect an operational state of the power unit 120, and/or control an operation of the power unit 120. The circuit board 110 may further include the conductive track 205. The conductive track 205 may be printed on the circuit board 110 to electrically connect the microcomputer unit 180 to the sensor unit 140. The circuit board 110 may further include the conductive track 203. The conductive track 203 may be printed on the circuit board 110 to electrically connect the microcomputer unit 180 to the baseband management controller unit 190.

The circuit board 110 may further include the plurality of sensors in the sensor unit 140. The microcomputer unit 180 may include the first microcomputer 180-1, which may be disposed on a first side of the circuit board 110, and the second microcomputer 180-2, which may be disposed on a second side of the circuit board 110. The first group of the plurality of sensors may be configured to send first signals to the first microcomputer 180-1, and the second group of the plurality of sensors may be configured to send second signals to the second microcomputer 180-2.

The circuit board 110 may further include the baseband management controller unit 190. The baseband management controller unit 190 may be disposed on the circuit board 110 and may be configured to communicate with a management server, receive status information of the storage system 100 from the microcomputer unit 180, provide a command to the microcomputer unit 180 about operation of the storage system 100, divide the storage media into groups, and/or provide a service based on an intelligent platform management interface specification for the storage system 100. The circuit board 110 may further include the conductive track 204. The conductive track 204 may be printed on the circuit board 110 to electrically connect the baseband management controller unit 190 to the input/output controller 170.

The circuit board 110 may further include the storage media being configured into a first group of storage media in which an operating system may be stored, and a second group of storage media which may be accessible to the server 10 of the server system 1000.

The circuit board 110 may further include the power slot 111. The power slot 111 may be disposed at the first end of the circuit board 110 and may be configured to be electrically connected to the power unit 120 of the storage system 100.

The circuit board 110 may further include the auxiliary connector 115. The auxiliary connector 115 may be disposed on the circuit board 110 and may be configured to be electrically connected to a (different) input/output controller that has a connection interface different from the second slot 116.

The input/output controller 170 of the storage system 100 usable in the server system 100 may include the chip 172 mounted on the board 171, the first connector 173, and the second connector 174. The first connector 173 may be disposed at an end of the board 171, may be connected to the first signal line 175 connected to the chip 172, and may be configured to facilitate communication of first information between the chip 172 and the server 10 usable in the server system 1000 according to the first interface bus method. The second connector 174 may be disposed at the end of the board, 171, may be connected to the second signal line 176 connected to the chip 172, and may be configured to facilitate communication of second information between the chip 171 and storage media of the storage system 100 of the server system 1000 according to the second interface method. The first connector 173 and the second connector 174 may be implemented as a single slot. The first interface bus method may be an interface that operates according to a Peripheral Component Interconnect Express standard, and the second interface bus method may be an interface that operates according to a Serial Attached Small Computer System Interface protocol, a Serial Advanced Technology Attachment protocol, or a Non-Volatile Memory Express specification.

The signal processor system of the storage system 100 usable in the server system 1000 may include the first signal processor 103 and the second signal processor 104. The first signal processor 103 may be configured to perform de-emphasis processing on a first signal transmitted from the storage unit 160 usable in the storage system 100 of the server system 1000 or the input/output controller 170 of the storage system 100. The second signal processor 104 may be configured to perform equalizer processing on a second signal received at the storage unit 160 or the input/output controller 170.

Although a few embodiments of the present general inventive concept have been shown and described, it will be appreciated by those skilled in the art that changes may be made in these embodiments without departing from the principles of the general inventive concept, the scope of which is defined in the appended claims and their equivalents.

## Claims

1. A storage system connectable to a server, the storage system comprising:
a communication unit configured to perform communication with the server;
a storage unit including a plurality of storage media;
an input/output (I/O) controller configured to transmit/receive data to/from the server through the communication unit, and transmit/receive the data to/from the storage unit; and
a board unit in which the storage unit and the I/O controller are disposed, and configured to transmit/receive the data between the storage unit and the I/O controller by using a pattern.

2. The storage system as claimed in claim 1, wherein the I/O controller is configured to cause the server to share and use storage spaces of the plurality of storage media.

3. The storage system as claimed in claim 1 or 2, further comprising:
a first interface bus configured to transmit/receive the data and a first control command between the server and the I/O controller; and
a second interface bus configured to transmit/receive the data and a second control command between the I/O controller and the plurality of storage media,
wherein the second interface bus is at least one of a serial attached small computer system interface (SAS), a serial advanced technology attachment (SATA), and a non-volatile memory express (NVMe) interface.

4. The storage system as claimed in claim 3, wherein the first interface bus is a peripheral component interconnect (PCI) Express interface bus.

5. The storage system as claimed in any one of claims 1 to 4, further comprising a signal processor disposed in the board unit, and configured to perform de-emphasis processing on a first signal transmitted from at least one of the storage unit and the I/O controller, and perform equalizer processing on a second signal received in at least one of the storage unit and the I/O controller.

6. The storage system as claimed in any one of claims 1 to 5, wherein the board unit includes a slot for connection to the I/O controller, and
the I/O controller is configured to be mounted on and detached from the slot.

7. The storage system as claimed in claim 6, wherein the slot includes:
a first slot configured to transmit/receive a first signal between the communication unit and the I/O controller; and
a second slot configured to transmit/receive a second signal between the I/O controller and the plurality of storage media.

8. The storage system as claimed in claim 7, wherein the first slot and the second slot are consecutively disposed.

9. The storage system as claimed in claim 7 or 8, wherein the first slot and the second slot are disposed to be spaced apart, and
the second slot has a pin arrangement specification of a PCI Express interface.

10. The storage system as claimed in any one of claims 1 to 9, wherein the board unit further includes a plurality of third slots for connection to the plurality of storage media, and
the plurality of storage media are configured to be mounted on and detached from the third slots.

11. The storage system as claimed in claim 10, wherein each of the plurality of storage media is configured to be mounted on and detached from each of the third slots through a sub board disposed perpendicular to the board unit.

12. The storage system as claimed in claim 11, wherein the sub board includes two fourth slots configured to connect to two storage media.

13. The storage system as claimed in claim 12, further comprising a plurality of brackets configured to fix the two storage media and the sub board to the board unit.

14. The storage system as claimed in any one of claims 1 to 13, further comprising a baseboard management controller (BMC) unit configured to provide intelligent platform management interface (IPMI) service for the storage system using status information of the storage system.

15. The storage system as claimed in claim 14, further comprising a microcomputer unit configured to collect status information of the plurality of storage media and status information of an inside of the storage system, provide the collected information to the BMC unit, and control an operation state of the storage system according to a control command provided from the BMC unit.
